# EUROPÄISCHE PATENTSCHRIFT

(11) **EP 0 734 459 B1**
(45) Veröffentlichungstag und Bekanntmachung des Hinweises auf die Patenterteilung: **03.02.1999**
(21) Anmeldenummer: 95901341.8
(22) Anmeldetag: 22.11.1994
(51) Int. Cl.: C23C 14/08, C23C 14/32, C23C 14/35, H01J 37/32, H01J 37/34

(54) **VERFAHREN UND EINRICHTUNG ZUM PLASMAAKTIVIERTEN BEDAMPFEN**
PLASMA-ACTIVATED VAPOUR-DEPOSITION PROCESS AND DEVICE
PROCEDE ET DISPOSITIF DE METALLISATION EN PHASE VAPEUR ACTIVEE AU PLASMA

(30) Priorität: 16.12.1993 DE 4343042
(43) Veröffentlichungstag der Anmeldung: 02.10.1996
(73) Patentinhaber: FRAUNHOFER-GESELLSCHAFT ZUR FÖRDERUNG DER ANGEWANDTEN FORSCHUNG E.V., 80636 München (DE)
(72) Erfinder: KIRCHHOFF, Volker, D-01324 Dresden (DE); GOEDICKE, Klaus, D-01307 Dresden (DE); NEUMANN, Manfred, D-01277 Dresden (DE); RESCHKE, Jonathan, D-01067 Dresden (DE); SCHILLER, Siegfried, D-01324 Dresden (DE)
(86) Internationale Anmeldenummer: DE9401415
(87) Internationale Veröffentlichungsnummer: WO9516798

(56) Entgegenhaltungen:
- DD-A- 252 205
- US-A- 5 133 849
- PATENT ABSTRACTS OF JAPAN vol. 6, no. 257 (C-140) 16. Dezember 1982 & JP,A,57 149 468 (SANYOU SHINKUU KOGYO) 16. September 1982

## Beschreibung

Die Erfindung betrifft ein Verfahren und die zugehörige Einrichtung zum plasmaaktivierten Beschichten, mit welchem vorzugsweise durch reaktives Verdampfen Schichten aus chemischen Verbindungen, z. B. Oxide, Nitride oder Karbide, im Vakuum aufgebracht werden. Solche Schichten dienen allgemein zur Oberflächenveredelung von Halbzeugen und Fertigteilen und zur Erzeugung funktionaler Oberflächen. Insbesondere dient das Verfahren dem Aufbringen von Oxidschichten mit Barrierewirkungen auf Kunststoffolien für die Verpackungsindustrie, um die Penetrationsrate von Sauerstoff und Wasserdampf herabzusetzen.

Für die Beschichtung großer Substrat flächen werden in großem Umfang Verdampfungsverfahren eingesetzt, um mit vergleichsweise niedrigen Beschichtungskosten metallische Schichten abzuscheiden. Die Herstellung von Verbindungsschichten durch reaktives Verdampfen, d. h. unter Wirkung eines reaktiven Gases zur Herstellung von Verbindungsschichten, erfordert je nach Art und Reaktionskinetik des Verdampfungsmaterials und des Reaktionsgases im allgemeinen eine hohe Substrattemperatur. Ist diese Temperatur störend, muß der Verdampfungsprozeß plasmaaktiviert durchgeführt werden. Werden statt des Verdampfens Katodenzerstäubungsverfahren (Sputtern) eingesetzt, so entsteht eine Plasmaaktivierung bereits durch den Mechanismus der Dampferzeugung. Die erreichbaren Abscheidemengen und damit die spezifischen Beschichtungskosten schränken die Anwendbarkeit solcher Verfahren, auch derjenigen mit Magnetfeldunterstützung wie das Magnetron-Sputtern, ein. Auch hybride Verfahren, bei denen im Wechsel aufgestäubte Schichten und aufgedampfte Schichten erzeugt werden, können die Abscheidemenge nur partiell erhöhen, und es entstehen sandwichartige Schichten mit Eigenschaften, die nur bestimmte Anwendungen zulassen.
Die bekannten Verdampfungsverfahren erfordern eine Plasmaaktivierung, die auf vielfältige Weise beschrieben worden ist und in zahlreichen Varianten praktiziert wird [H. Frey u. G. Kienel: Dünnschichttechnologie VDI Düsseldorf 1987, Kpa. 4].

Die bekanntesten Verfahren hierzu sind: Das Elektronenstrahlverdampfen mit einer ringförmigen Zusatzelektrode als ARE-Prozeß [Activated reaktive evaporation] (Bunshah und Rosghuram, Journ. Vac. Sci. Technol. Band 9, No. 6, 1972, Seiten 1385 - 1388), die Verwendung von Verdampfern gemeinsam mit separaten Ionenstrahlquellen (DE 39 31 565 C1), die Verwendung von Verdampfern mit Hochfrequenz-Entladungen, Elektronenstrahlverdampfer mit separater Plasmaquelle, Elektronenstrahlverdampfer mit zusätzlichem Innenraum und Zusatzelektrode (DE 36 27 151 A1).

Aus unterschiedlichen Gründen, vor allem wegen der Begrenzung der erreichbaren Abscheidemenge, der hohen Kosten und der Beschränkung auf kleine beschichtbare Substratflächen, hat jedes Verfahren nur eine spezielle Anwendung gefunden. Alle diese Verfahren mit Elektroden im Dampfraum haben gemeinsam den Nachteil einer mangelhaften Prozeßstabilität und geringen Funktionszeit, wenn elektrisch isolierende Verbindungsschichten abgeschieden werden. Hochfrequenzentladungen. ohne Elektroden im Dampfraum sind für viele Anwendungen zu kostenaufwendig.

Es ist bekannt, für Zerstäubungsprozesse das Problem der mangelhaften Prozeßstabilität beim Abscheiden isolierender Schichten durch Pulsverfahren oder Doppelanordnungen von Zerstaubungsquellen mit Wechselspannungsquellen im Mittelfrequenzbereich zu lösen (DD 252205 A1). Die erreichbare Beschichtungsmenge und damit die Kosten solcher Verfahren sind jedoch um ein bis zwei Größenordnungen ungünstiger als beim Verdampfen.

Aus der Druckschrift US-A-5 133 849 ist ein Verfahren bekannt, wobei ein Verdampfungsmaterial aus einer erhitzten Quelle verdampft wird, der Dampf teilweise durch einen Glühfaden ionisiert wird, und gleichzeitig eine weitere Dampfkomponente aus einem Sputtertarget verdampft wird.

Der Erfindung liegt die Aufgabe zugrunde, ein Verfahren und eine Einrichtung zum plasmaaktivierten Bedampfen zu schaffen, um bei hoher Abscheidemenge (auch Abscheiderate genannt) und über lange Prozeßzeiten stabil das Aufbringen von Schichten im Vakuum, insbesondere auch die reaktive Herstellung von Schichten aus elektrisch isolierenden Verbindungen, zu gewährleisten. Durch Beeinflussung der Plasmadichte im Prozeß sollen die Reaktivität und energetische Aktivierung und die Schicht zusammensetzung und Schichtstruktur gezielt eingestellt und konstant gehalten werden.

Erfindungsgemäß wird die Aufgabe nach den Merkmalen des Patentanspruches 1 gelöst. In den Unteransprüchen 2 - 13 sind weitere vorteilhafte Ausgestaltungen des erfindungsgemäßen Verfahrens beschrieben. Die Einrichtung zur Durchführung des Verfahrens ist in den Ansprüchen 14 bis 18 beschrieben.
Das Verdampfungsmaterial kann zur Durchführung des Verfahrens aus einem Tiegel, z. B. aus einem durch einen Elektronenstrahl beheizten Tiegel oder eine Reihe von einzelnen Verdampfern, z. B. sogenannten Flashverdampfern oder boat-Verdampfern, wie sie für die Aluminiumverdampfung in Bandbeschichtungsanlagen bekannt sind, verdampft werden. Es ist aber auch eine tiegellose Verdampfung, etwa durch Sublimation eines von einem programmiert abgelenkten Elektronenstrahl geheizten Quarzrohres im Falle der Abscheidung von Siliziumoxidschichten, möglich. Das Verfahren eignet sich im Grundsatz für alle bekannten Arten der direkten und indirekten Heizung des Verdampfungsmaterials.
Die Elektroden begrenzen zweckmäßigerweise möglichst weitgehend den Bereich zwischen dem Verdampfungsgut und der Substratebene und bilden einen Raum, in dem ein dichter Dampf und ein vorzugsweise magnetfeldverstärktes Plasma gleichzeitig erzeugt werden, so daß sich Dampf und Plasma durchdringen und durch Stoßprozesse ihrer Spezies wechselwirken. Für die reaktive Verdampfung wird als weitere Verfahrenskomponente der Fluß oder Partialdruck des reaktiven Gases, das als Komponente der abzuscheidenden chemischen Verbindung dient, eingestellt und konstant gehalten oder geregelt. Die Plasmaerzeugung geht vom Nahbereich derjenigen Elektroden aus, die momentan mit dem negativen Pol der Stromquelle verbunden sind (Katode). Andere Elektroden, die momentan mit dem positiven Pol der Stromquelle verbunden sind, dienen als Anode für die Plasmaerzeugung. Die Elektroden können durch Änderung der Polarität ihre Funktion als Katode bzw. Anode für die Plasmaerzeugung vertauschen. Die Elektroden bestehen im Bereich ihrer Grenzfläche zum Dampfraum und zum Plasma aus dem Verdampfungsmaterial oder einer seiner Komponenten und haben zwecknäßigerweise eine Dicke von mehreren Millimetern und sind vorzugsweise im Magnetfeld angeordnet. Die Elektroden sind bekannterweise mit einer Abschirmung und einem Mittel zur Kühlung, z. B. einer Wasserkühlung, ausgerüstet. Um mit dem Verfahren sehr hohe Abscheidemengen zu erreichen, sind besonders solche Magnetfelder geeignet, die auf jeder der Elektroden ein separates Magnetfeld von der bekannten Form eines Magnetronfeldes erzeugen, wie es beim Magnetron-Sputtern angewendet wird. Es ist auch vorteilhaft, magnetische Multipol-Magnetfelder zu verwenden, die im Bereich der Elektroden eine periodische Anordnung von Nord- und Südpolen in paralleler oder antiparalleler Polung aufweisen und in der Plasmatechnologie zur Führung und Verstärkung von Plasmen bekannt sind.
Unter der Wirkung des Plasmas findet zumindest auf einem Bereich der momentan als Katode wirkenden Elektroden ein Abstäuben der dem Plasma und Dampf zugewandten Oberfläche statt. Durch Bemessung der Verdampfungsmenge und Einstellen der Abstäubemenge wird unter Berücksichtigung der Rückstäubemenge, die sich durch Dampfstreuung im Plasma ergibt, die Prozeßführung so gestaltet, daß sich im zeitlichen Mittel ein resultierender Abtrag der Elektrodenoberfläche ergibt. Diese Relation wird für den Bereich der Elektrodenoberfläche eingestellt, der die höchste Abstäubemenge aufweist.
Es wurde gefunden, daß die Plasmaerzeugung bei hinreichend hoher Verdampfungsmenge allein im Dampf möglich ist. Auf diese Weise unterscheidet sich das Verfahren und damit der Mechanismus der Schichtbildung grundsätzlich von allen Sputterverfahren. Plasmadichte, Energieverteilung der Spezies von Dampf und Plasma und das äußere Erscheinungsbild des Plasmas für eine gegebene Elektroden- und Magnetfeldanordnung werden durch die Dampfdichteverteilung entscheidend beeinflußt und stimmen nicht mit den vom Zerstäuben her bekannten Verhältnissen überein.

Das Verfahren kann im Dampf des Verdampfungsmaterials und gegebenenfalls im eingelassenen Reaktivgas durchgeführt werden, aber es kann auch zweckmäßig sein, zusätzlich ein inertes Gas einzulassen. Vorteile dieser Verfahrensweise bestehen darin, die Abstäubemenge an den Elektroden und damit die effektive Abscheidemenge erhöhen zu können und/oder bei gegebener, durch die Elektrode eingespeister Energie, die Brennspannung für die Plasmaerzeugung und damit auch die Energieverteilung der Spezies im Plasma geeignet einstellen zu können.

Die gegenseitige Durchdringung und Wechselwirkung von Dampf und Plasma wird erfindungsgemäß durch die Art der geometrischen Anordnung der Elektroden eingestellt. Dazu werden die Elektroden so angeordnet, daß eine Komponente ihrer Flächennormale in die Richtung der entsprechenden Komponente der Flächennormale der übrigen Elektroden zeigt. Die Elektroden sind also mit ihrer wirksamen Oberfläche in Richtung der höchsten Dampfdichte angeordnet. Damit wird der Raum zur Ausbildung des Plasmas im wesentlichen auf das Gebiet des Dampfausbreitungsraumes begrenzt. Weiterhin bilden die Elektroden jedoch zur Substratebene einen einstellbaren Winkel α. Durch die Bemessung dieses Winkels α werden die für die angestrebte Plasmaaktivierung des Aufdampfprozesses bevorzugt ablaufenden Wirkungen in bezug auf ihre Wahrscheinlichkeit verändert. Ein kleiner Winkel α erhöht bevorzugt die Wahrscheinlichkeit von Anregung und Stoßionisation des Dampfes im Dampfvolumen. Ein großer Winkel α erhöht dagegen bevorzugt die energetische Aktivierung des Abscheide- und Schichtbildungsvorganges auf den Substraten. Je nach Art der abzuscheidenden Schichten, der Reaktionskinetik und der angestrebten Zusammensetzung der Schicht wird das Verfahren deshalb entweder mit Dominanz von Anregung und Stoßionisation im Dampf (d. h. kleinerem Winkel α) oder mit Dominanz der energetischen Aktivierung des Kondensationsprozesses am Substrat (d. h. größerer Winkel α) geführt. Da eine Veränderung des Winkels α jedoch auch die oben genannte Relation zwischen Aufdampfmenge, Abstäubemenge und Rückstäubemenge an den Elektroden verändert, wird der optimale Winkel α zweckmäßigerweise experimentell ermittelt.

Wie bei anderen Verfahren zum reaktiven Aufdampfen wird die Zusammensetzung der Schicht auf den Substraten durch Einstellung des Flusses des reaktiven Gases und/oder des inerten Gases bestimmt. Beim erfindungsgemäßen Verfahren kann jedoch speziell auch ein hoher Partialdruck des reaktiven Gases angewendet werden, ohne daß die Prozeßstabilität beeinträchtigt wird.

Sollen Schichten mit einem Dotierungsmaterial aufgedampft werden, so wird mindestens eine Elektrode aus diesem Dotierungsmaterial eingesetzt. Durch Einstellung der durch die Elektroden eingespeisten elektrischen Leistung in Relation zur Verdampfungsmenge wird der Grad der Dotierung festgelegt. Durch eine zeitliche Steuerung kann insbesondere auch ein Gradient der Dotierung in Abhängigkeit von der Schichtdicke erreicht werden.

Wenn bei Temperaturen von einigen hundert Grad Celsius bereits ein nennenswerter Dampfdruck der abzuscheidenden Verbindung erreicht ist, ist es zweckmäßig, eine definierte, begrenzte Kühlleistung an den Elektroden derart einzustellen, daß sich eine hohe Oberflächentemperatur einstellt und die Abstäubemenge durch einen weiteren Betrag, die Menge der thermischen Verdampfung an den Elektroden, erhöht wird. Auf diese Weise gelingt es z. B. für die plasmaaktivierte Abscheidung von Siliziumoxid, die Abscheidemenge auf den Substraten um den Faktor 3 zu erhöhen.

Um das Verfahren langzeitstabil zu kontrollieren und zu regeln, ist es zweckmäßig, den Fluß des reaktiven Gases durch Überwachung einer relevanten Plasmakenngröße zu regeln. Dazu eignet sich z. B. die Spannung zwischen den Elektroden. Besonders geeignet ist jedoch ein Signal, das aus der optischen Emission des Plasmas abgeleitet wird.

Bei einer anderen Variante zur Durchführung des Verfahrens wird der Fluß des reaktiven und gegebenenfalls des inerten Gases konstant gehalten, und die an den Elektroden eingespeiste Energie wird mittels einer relevanten Kenngröße des Plasmas geregelt.

Zur Einspeisung der Energie durch die Elektroden eignen sich in bekannter Weise Wechselstromquellen oder Gleichstromquellen mit getakteter oder programmiert schaltbarer Polumkehr. Die Polwechselfrequenz muß um so höher sein, je größer die Aufdampfmenge ist, je höher der spezifische elektrische Widerstand der abzuscheidenden Verbindung ist und je höher die Anforderung an eine defektfreie Beschichtung ist. Bei vergleichsweise geringen Anforderungen ist eine Polwechselfrequenz im Bereich von einigen Herz bis etwa in den Bereich der Netzfrequenz (50 bis 300 Hz) ausreichend. Für hohe Anforderungen im o. g. Sinne sind Mittelfrequenzgeneratoren im Frequenzbereich von 10 bis 500 kHz erforderlich. Technisch am einfachsten sind Generatoren mit sinusförmiger Wechselspannung.

Das Verfahren mit den erfindungsgemäßen Merkmalen kann mit der höchsten Abscheidemenge durchgeführt werden, wenn eine bipolare gepulste Spannung bei einer so hohen momentanen Stromstärke verwendet wird, daß die an den Elektroden eingespeiste Leistung während der Pulszeit die im zeitlichen Mittel gelieferte, durch die technischen Grenzen der Elektrodenkühlung bestimmte Leistung übersteigt. Durch einen auf diese Weise erzeugten Betrieb mit periodisch höherer Plasmadichte konnten besonders vorteilhafte Schichteigenschaften nachgewiesen werden.

Anhand von zwei Ausführungsbeispielen wird die Erfindung näher erläutert. In den zugehörigen Zeichnungen zeigen:
Fig. 1: eine Einrichtung zum Beschichten von ebenen Substraten mit aluminiumdotiertem Zinkoxid,
Fig. 2: eine Einrichtung zum Beschichten von Folien mit Aluminiumoxid mittels einer linienförmig ausgebildeten Verdampfungseinrichtung.

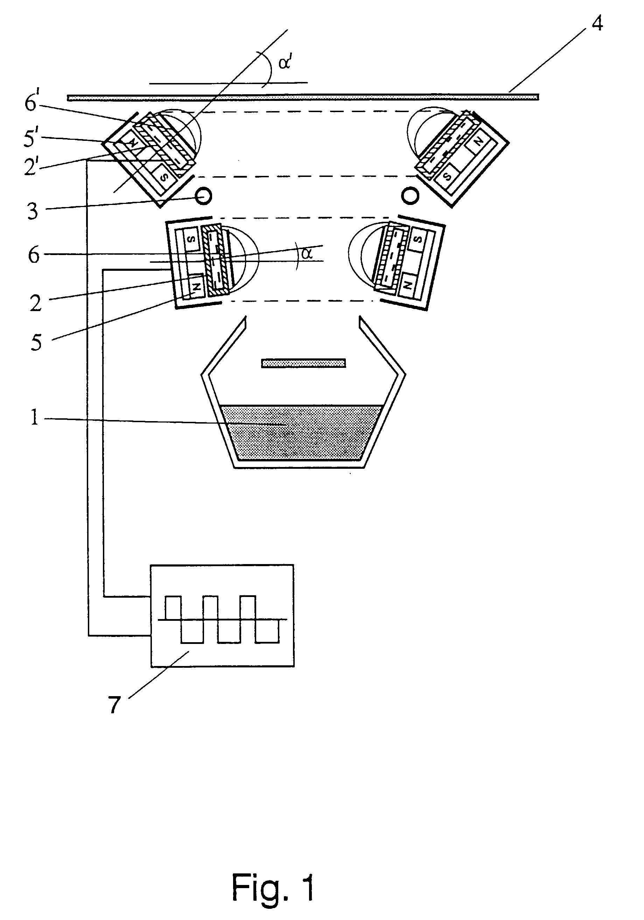

Die in Fig. 1 im Querschnitt dargestellte Bedampfungseinrichtung besteht aus einem thermisch beheizten Verdampfer 1 für Zink, Elektroden 2 und 2' und einem Gaseinlaßsystem 3 im Nahbereich des Verdampfers 1. Die zu beschichtenden Substrate 4 bestehen aus Glas mit der Abmessung 50 x 50 cm² und werden zum Aufbringen einer Al-dotierten ZnO₂-Schicht linear durch die Dampf zone bewegt. Die Elektrode 2 besteht aus einem dickwandigen, direkt wassergekühlten verzinkten Profil, d. h. aus dem Verdampfungsmaterial, die Elektrode 2' besteht aus einem Aluminiumprofil, d. h. aus Dotierungsmaterial. Beide Elektroden 2; 2' sind an den zur Zeichenebene parallelen Seiten geschlossen und bilden dadurch jeweils einen Ring. Die Elektrode 2 ist in der Nähe des Verdampfers 1 und die Elektrode 2' in Substratnähe angeordnet. Die Neigungswinkel zu der Substratebene betragen α für Elektrode 2 bzw. α' für die Elektrode 2'. Jede Elektrode 2; 2' besitzt auf der dem Dampf abgewandten Seite eine Magnetanordnung 5; 5', welche einen geschlossenen ringförmigen Bereich 6 mit einem Magnetfeld erzeugt, das parallel zur Elektrodenoberfläche gerichtet ist. Als Stromquelle 7 wird ein Wechselspannungsgenerator verwendet, der erdfrei mit den Elektroden 2 und 2' verbunden ist.

Er dient zur Erzeugung einer bipolaren gepulsten Leistung mit wählbarer Pulsform bei einer Frequenz von 30 kHz.

Diese Einrichtung dient zur Durchführung des erfindungsgemäßen Verfahrens in folgender Weise:
Im Dampfraum zwischen dem Verdampfer 1, den Substraten 4 und den Elektroden 2 und 2' breitet sich der Dampf aus, der bei einer Heizleistung von 15 kW am Verdampfer 1 eine "stationäre" Beschichtungsmenge von etwa 400 nm/s auf dem Substrat 4 erzeugt. Durch Einspeisung einer Leistung von 12 kW an den Elektroden 2; 2' wird ein Plasma aufrechterhalten, das im Dampf ohne Einlaß von inertem Gas bei einem Sauerstoff-Fluß von 30 sccm/s existiert und in Wechselwirkung mit dem Dampf ist. So werden z. B. die Beschichtungsmenge und die Charakteristik der Dampfausbreitung entscheidend durch das Plasma verändert. Durch iterative Veränderung der Winkel α für die Elektrode 2 und α' für die Elektrode 2' werden die optimalen Werte von α = 10° und α' = 30° bestimmt. Unter diesen Bedingungen werden beide Elektroden 2; 2' im zeitlichen Mittel überwiegend abgestäubt. Nur in Randbereichen der Elektrodenoberfläche bildet sich eine elektrisch isolierende Aufdampfschicht.

Die Einspeisung der elektrischen Leistung an der Stromquelle 7 erfolgt für die beiden Polungen unsymmetrisch durch Einstellung der Pulsform der Spannung. Dadurch wird der Grad der Dotierung beeinflußt. Durch ein aus der optischen Emission des Plasmas gebildetes Signal, welches die Linienintensitäten von Zink und Aluminium auswertet, wird die Dotierung geregelt.

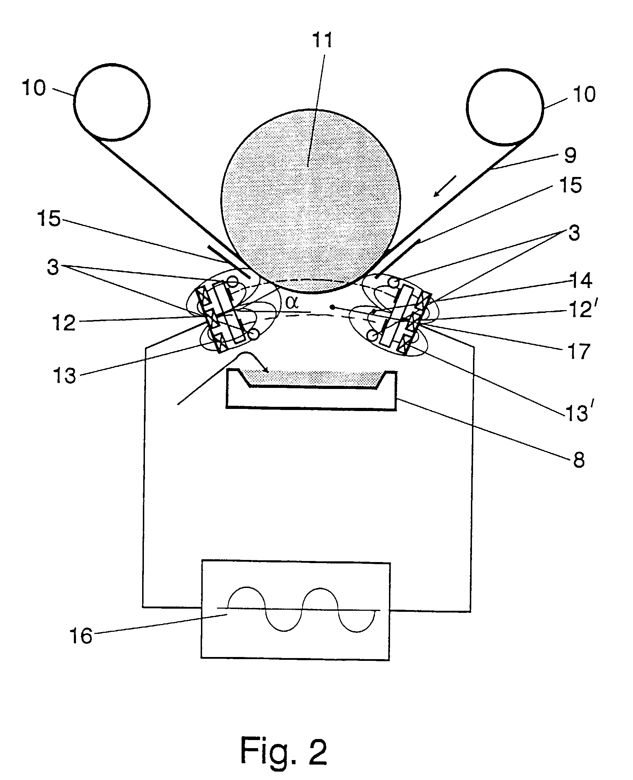

Werden die Substrate 4 mit einer linearen Transportgeschwindigkeit von 1 m/s bewegt, so werden hochwertige transparente Al-dotierte Zinkoxidschichten mit einer Dicke von 120 nm abgeschieden. Die in Fig. 2 im Querschnitt dargestellte Bedampfungseinrichtung dient dem plasmagestützten reaktiven Aufdampfen von Aluminiumoxid auf Kunststoffolie im Vakuum.
Der Verdampfer 8 besteht aus einer Reihe von fünfzehn gleichartigen, direkt geheizten boat-Verdampfern. Bei ihnen wird das Verdampfungsmaterial Aluminium in Drahtform auf einen aus Titanborid bestehenden Block gebracht und verdampft flash-artig.

Insgesamt wird eine Dampfwolke in einem Bereich von 1,6 m Breite erzeugt. Das zu beschichtende Substrat, eine Kunststoffolie 9, gleicher Breite, wird im Vakuum durch Abwickel- und Aufwickelvorrichtungen 10 über Führungswalzen und eine Kühlwalze 11 durch den Bedampfungsbereich geführt. Seitlich ist dieser Bereich durch je eine Elektrode 12; 12' begrenzt. Die wirksame Elektrodenfläche beträgt je 0,12 m x 1,6 m. Beide Elektroden 12; 12' sind symmetrisch angeordnet und bilden einen Winkel α = 15° zwischen der jeweiligen Flächennormale und der Substratebene. Die Elektroden 12; 12' sind wassergekühlt und rückseitig abgeschirmt. Sie bestehen aus 8 mm dicken Aluminiumplatten. Durch ein System aus Permanentmagneten 13; 13' auf der dem Dampf abgewandten Seite der Elektroden 12; 12' entsteht auf jeder der wirksamen Elektrodenflächen ein Magnetfeld in Form eines "unbalancierten" Magnetfeldes 14. Es ist durch einen in sich geschlossenen Bereich mit einer Magnetfeldstärke parallel zur Elektrodenfläche und durch weit in den Dampfraum tretende Feldlinien im Bereich des Mittelpols der Magnetanordnung gekennzeichnet. Die Einrichtung enthält außerdem ein ringförmiges Gaseinlaßsystem 3 für das Reaktivgas Sauerstoff-Argon-Gemisch und Sensoren für eine in situ-Messung der Intensität der optischen Emission des Plasmas.
Die Elektroden 12; 12' sind mit einem Wechselstromgenerator 16 verbunden, der eine sinusförmige Wechselspannung bei der Leistung von 100 kW und bei einer Frequenz von 100 kHz erzeugt.
Mit dieser Einrichtung wird das erfindungsgemäße Verfahren wie folgt durchgeführt:
Nach Justage der Heizströme für die einzelnen boat-Verdampfer 8 wird auf der gesamten Substratbreite eine Aufdampfrate für metallisches Aluminium erreicht, die bei einer Transportgeschwindigkeit der Kunststoffolie 9 von 2 m/s einer Schichtdicke von 40 nm ± 10 % entspricht. Nach Einstellung eines Gasflusses von 10 sccm/s und Einschalten des Wechselstromgenerators 16 bildet sich ein stationäres Plasma aus, das den gesamten Dampfraum erfüllt. Es hat seine größte Dichte in einem Bereich 17 mit bogenförmigem Querschnitt, der von dem Mittelbereich der Elektroden 12; 12' ausgeht und die Kunststoffolie 9 tangiert. Die an den Elektroden 12; 12' eingespeiste Leistung wird so weit erhöht, bis transparente Schichten auf der Kunststoffolie 9 entstehen und sich auf beiden Elektroden 12; 12' ringförmige Erosionszonen bilden, in denen die Elektrodenoberfläche metallisch bleibt. Hier gilt, daß die Abstäubemenge des unter der Wirkung der Plasmas abgetragenen Elektroden 12; 12' im dynamischen Gleichgewicht etwas höher ist als die Summe aus Aufdampfmenge und Rückstäubemenge. Auf den übrigen Elektrodenbereichen wächst mit fortschreitender Prozeßzeit eine Schicht auf, die aus dunkel gefärbten Suboxiden des Aluminiums besteht und elektrisch isolierend ist. Dieser Zustand der Elektrodenoberfläche kann visuell kontrolliert werden. Es hat sich als zweckmäßig erwiesen, die Abstäubemenge etwa auf das 1,5fache der ohne Plasma experimentell ermittelten Aufstäubemenge im Bereich der Elektrodenfläche einzustellen. Im weiteren Prozeßverlauf wird mittels optischer Emissionsspektroskopie ein an drei Prozeßorten gebildetes Steuersignal benutzt, um bei konstantem Gasfluß die in die Elektroden 12; 12' eingespeiste Leistung so zu regeln, daß das Signal konstant bleibt. Schwankungen der Verdampfungsmenge von etwa ± 20 % können auf diese Weise ebenfalls ausgeregelt werden. Mit den angegebenen Parametern entsteht eine transparente, stöchiometrische, etwa 30 nm dicke Aluminiumoxidschicht bei der angegebenen Transportgeschwindigkeit der Kunststoffolie 9 und bei hoher Prozeßstabilität.
Soll die Aufdampfmenge um mehr als 20 % geändert werden, so müssen die Prozeßparameter in anderer Weise aufeinander abgestimmt werden. Das betrifft insbesondere auch den Neigungswinkel α der Elektroden 12; 12'. Eine Grenze für die weitere Erhöhung der Abscheidemenge ergibt sich aus der technischen Grenze für die Funktion der Kühlung der direkt wassergekühlten Elektroden 12; 12'.

## Patentansprüche

1. Verfahren zum plasmaaktivierten Bedampfen, vorzugsweise zur reaktiven Beschichtung von Substraten im Vakuum durch Verdampfen eines direkt oder indirekt erhitzten Verdampfungsmaterials, **dadurch gekennzeichnet,** daß der sich ausbreitende Dampf zunächst teilweise von einem Plasma, welches von mindestens zwei Elektroden, die zeitlich wechselweise durch dieses Plasma abgestäubt werden, aufrecht erhalten wird, durchdrungen und zur Wechselwirkung gebracht wird, daß Elektroden aus dem Verdampfungsmaterial oder einer Komponente des Verdampfungsmaterials und/oder einem Dotierungsmaterial, das der aufzubringenden Schicht hinzugefügt werden soll, verwendet werden, und daß das Plasma allein im Dampf des Verdampfungsmaterials und gegebenenfalls im reaktiven Gas und/oder einem inerten Gas aufrechterhalten wird.

2. Verfahren nach Anspruch 1, **dadurch gekennzeichnet,** daß für die reaktive Beschichtung zur Herstellung elektrisch hoch isolierender Verbindungen auf mindestens einem Anteil der wirksamen Oberfläche jeder Elektrode die Abstäubemenge im zeitlichen Mittel mindestens so groß wie die Summe aus der Aufdampfmenge des Dampfes und der Rückstäuberate eingestellt wird.

3. Verfahren nach Anspruch 1 und 2, **dadurch gekennzeichnet,** daß das von den Elektroden erzeugte Plasma magnetisch geführt und konzentriert wird.

4. Verfahren nach Anspruch 3, **dadurch gekennzeichnet,** daß das Plasma nach der Art und Wirkungsweise einer unbalancierten oder balancierten Magnetronentladung geführt und konzentriert wird.

5. Verfahren nach Anspruch 1 bis 4, **dadurch gekennzeichnet,** daß die Zusammensetzung der reaktiv abgeschiedenen Schicht auf den Substraten durch Einstellung des Flusses des reaktiven und/oder des inerten Gases festgelegt wird.

6. Verfahren nach Anspruch 5, **dadurch gekennzeichnet,** daß der Fluß des reaktiven und/oder inerten Gases in Abhängigkeit von einer in situ gemessenen relevanten Prozeßgröße geregelt wird.

7. Verfahren nach Anspruch 1 bis 6, **dadurch gekennzeichnet,** daß die durch die Elektroden eingespeiste elektrische Leistung in Abhängigkeit von einer in situ gemessenen relevanten Prozeßgröße bei konstant gehaltenem Fluß des reaktiven und gegebenenfalls des inerten Gases geregelt wird.

8. Verfahren nach Anspruch 1 und mindestens einem der Ansprüche 2 bis 7, **dadurch gekennzeichnet,** daß als relevante Prozeßgröße die Intensität der optischen Emission an einem oder mehreren Orten im Plasma gemessen wird.

9. Verfahren nach Anspruch 1 und mindestens einem der Ansprüche 2 bis 8, **dadurch gekennzeichnet,** daß durch Regelung der Kühlleistung für die Elektroden eine bestimmte, vorzugsweise hohe Temperatur der wirksamen Oberfläche der Elektroden eingestellt wird.

10. Verfahren nach Anspruch 1 und mindestens einem der Ansprüche 2 bis 9, **dadurch gekennzeichnet,** daß der Grad der Dotierung der abgeschiedenen Schichten mittels der durch die Elektroden eingespeisten elektrischen Leistung und/oder der Kühlleistung für die Elektroden geregelt wird.

11. Verfahren nach Anspruch 1 und mindestens einem der Ansprüche 2 bis 10, **dadurch gekennzeichnet,** daß an die Elektroden eine regelbare sinusförmige Wechselspannung angelegt wird.

12. Verfahren nach Anspruch 1 und einem der Ansprüche 2 bis 10, **dadurch gekennzeichnet,** daß an die Elektroden eine bipolare gepulste Spannung angelegt wird.

13. Verfahren nach Anspruch 12, **dadurch gekennzeichnet,** daß der Momentanwert der Leistung während der Puls zeit so geregelt wird, daß die im zeitlichen Mittel gelieferte, durch die technischen Grenzen der Kühlung der Elektroden bestimmte Leistung überschritten wird.

14. Einrichtung zur Durchführung des Verfahrens nach Anspruch 1, bestehend aus einer im Vakuum angeordneten Verdampfungseinrichtung zum direkten oder indirekten Verdampfen des Verdampfungsgutes, Elektroden, vorzugsweise solchen, deren wirksame Oberfläche von einem magnetischen Feld nach Art einer Magnetronkatode durchdrungen sind, Mittel zum Einlassen von Gasen und einer Spannungsquelle zur Aufrechterhaltung einer nichtthermischen Entladung zur Plasmaerzeugung, **dadurch gekennzeichnet,**
daß die Elektroden (2; 2') im Raum zwischen den Substraten (4; 9) und dem Verdampfungsmaterial so angeordnet sind, daß die zur Substratebene parallele Komponente der Flächennormale jeder Elektrode (2; 2') in Richtung der höchsten Dampfdichte gerichtet ist und daß die Flächennormale jeder Elektrode (2; 2') mit der Substratebene einen im Bereich 0 ≤ α ≤ 90° einstellbaren Winkel mit der Substratebene bildet,
daß jede Elektrode (2; 2') elektrisch isoliert und mit einem der beiden Pole einer mit Polwechselschaltung ausgestatteten Stromquelle (7; 16), vorzugsweise einer bipolaren Wechselspannungsquelle verbunden ist,
daß die Elektroden (2; 2') mit einer Wasserkühlung, vorzugsweise mit einstellbarer Kühlleistung, versehen sind,
daß die Mittel zum Einlassen von Gasen im Raum zwischen dem Verdampfungsmaterial und den Substraten (4; 9) angeordnet sind.

15. Einrichtung nach Anspruch 14, **dadurch gekennzeichnet,** daß beide Pole der Stromquelle (7; 16) sowohl gegenüber den Substraten (4; 9) als auch gegenüber der Verdampfungs- und Gaseinlaßeinrichtung elektrisch isoliert sind.

16. Einrichtung nach Anspruch 14 und 15, **dadurch gekennzeichnet,** daß die geometrische Form und Größe der Elektrodenoberflächen weitgehend der dampfabgebenden Fläche der Verdampfungseinrichtung angepaßt ist.

17. Einrichtung nach Anspruch 14 bis 16, **dadurch gekennzeichnet,** daß eine weitere Stromquelle zur Einstellung einer vorgegebenen Potentialdifferenz zwischen den Substraten (4; 9) und einer der Elektroden (2; 2') angeschlossen ist.

18. Einrichtung nach Anspruch 14 bis 17, **dadurch gekennzeichnet,** daß weitere magnetfelderzeugende Einrichtungen in der Nähe der Substrate (4; 9) angeordnet sind, die das Plasma in grundsätzlich bekannter Weise führen.

## Claims

1. Method for plasma-activated vapour deposition, preferably for reactive coating of substrates in a vacuum by vapour deposition of a directly or indirectly heated evaporating material, characterised in that the dispersing vapour is firstly penetrated by plasma, which is maintained by at least two electrodes which chronologically alternatingly have dust removed by this plasma, and said vapour is brought into interaction, in that electrodes are used of the evaporating material or a component of the evaporating material and/or a doping material, which is to be added to the coating to be applied, and in that the plasma is maintained only in the vapour of the evaporating material and if necessary in the reactive gas and/or an inert gas.

2. Method according to claim 1, characterised in that for reactive coating in order to produce electrically highly insulating compounds on at least a proportion of the effective surface of each electrode, the quantity of dust removed on a time average is at least as large as the sum or line avaporated on quantity of the vapour and of the back-dust removal rate.

3. Method according to claim 1 and 2, characterised in that the plasma generated by the electrodes is magnetically guided and concentrated.

4. Method according to claim 3, characterised in that plasma is guided and concentrated according to the type and effect of an unbalanced or balanced magnetron discharge.

5. Method according to claim 1 to 4, characterised in that the composition of the reactively deposited coating on the substrates is determined by adjustment of the flow of the reactive and/or of the inert gas.

6. Method according to claim 5, characterised in that the flow of the reactive and/or inert gas is adjusted in dependence of a relevant process parameter measured in situ.

7. Method according to claim 1 to 6, characterised in that the electrical power applied through the electrodes is regulated in dependence of a relevant process parameter measured in situ with a constantly-maintained flow of the reactive and if necessary of the inert gas.

8. Method according to claim 1 and at least one of claims 2 to 7, characterised in that intensity of the optical emission on one or more points in the plasma is measured as a relevant process parameter.

9. Method according to claim 1 and at least one or claims 2 to 8, characterised in that, in order to regulate the cooling performance for the electrodes, a specific, preferably high temperature of the effective surface of the electrodes is set.

10. Method according to claim 1 and at least one of claims 2 to 9, characterised in that the degree of doping of the coatings deposited is regulated by the electrical power applied through the electrodes and/or the cooling performance for the electrodes.

11. Method according to claim 1 and at least one of claims 2 to 10, characterised in that an adjustable sinusoidal alternating voltage is applied to the electrodes.

12. Method according to claim 1 and one of claims 2 to 10, characterised in that a bi-polar pulse voltage is applied to the electrodes.

13. Method according to claim 12, characterised in that the momentary value of the power during the pulse times is so adjusted that the power supplies per unit or time, determined by the technical thresholds of cooling of the electrodes, is exceeded.

14. Device for carrying out the method according to claim 1, consisting of an evaporation device located in a vacuum, for direct or indirect evaporation or the evaporation material, electrodes, preferably those whose effective surface is penetrated by a magnetic field after the manner of a magnetron cathode, means for introducing gases and a voltage source for maintaining a non-thermal discharge for plasma generation, characterised in that
the electrodes (2;2') are arranged in the space between the substrates (4;9) and the evaporating material so that the component parallel to the substrate plane, of the surface normal of each electrode (2;2') is aligned in the direction of the highest vapour density, and in that the surface normal of each, electrode (2;2') forms with the substrate plane an angle adjustable in a range 0 ≤ α ≤ 90° with the substrate plane,
in that each electrode (2;2') is electrically insulated and connected to one of the two poles of a current source equipped with a polarity change circuit (7;16), preferably a bi-polar alternating current source,
in that the electrode (2;2') are provided with a water cooling system, preferably with an adjustable cooling performance,
in that the means for introducing gases are located in the space between the evaporating material and the substrates (4;9).

15. Device according to claim 14, characterised in that both poles of the current source (7;16) are electrically insulated both from the substrates (4;9) and also from the evaporating and gas inlet device.

16. Device according to claim 14 and 15, characterised in that the geometric shape and size of the electrode surfaces are extensively adapted to the vapour-emitting surface of the evaporating device.

17. Device according to claim 14 to 16, characterised in that a further current source for setting a predetermined potential difference is connected between the substrates (4;9) and one of the electrodes (2;2').

18. Device according to claim 14 to 17, characterised in that further devices generating magnetic fields are located in the vicinity of the substrate (4;9), which guide the plasma in a basically known way.

## Revendications

1. Procédé de métallisation activé au plasma, de préférence pour l'enduction réactive de substrats sous vide par vaporisation d'un matériau apte à la vaporisation chauffé directement ou indirectement,
caractérisé en ce que
- la vapeur se répandant est pénétrée et amenée à l'interaction d'abord partiellement par un plasma, qui est obtenu par au moins deux électrodes, qui sont époussetées dans le temps alternativement par ce plasma,
- sont utilisées des électrodes composées du matériau de vaporisation ou d'un composant du matériau de vaporisation et/ou d'un matériau de dopage, qui doit être ajouté à la couche à appliquer, et
- le plasma est maintenu seulement dans la vapeur du matériau de vaporisation et éventuellement dans le gaz réactif et/ou dans un gaz inerte.

2. Procédé selon la revendication 1,
caractérisé en ce que
pour l'enduction réactive, on ajoute pour la fabrication de combinaisons fortement isolées électriquement sur au moins une partie de la surface efficace de chaque électrode la quantité d'époussetage en moyenne dans le temps au moins aussi importante que la somme provenant de la quantité métallisée de vapeur et du taux d'époussetage retenu.

3. Procédé selon les revendications 1 et 2,
caractérisé en ce que
le plasma créé par les électrodes est guidé magnétiquement et concentré.

4. Procédé selon la revendication 3,
caractérisé en ce que
le plasma est guidé et concentré à la manière d'une décharge de magnétron équilibrée ou non équilibrée.

5. Procédé selon les revendications 1 à 4,
caractérisé en ce que
la composition de la couche réactive déposée est fixée sur les substrats par réglage du flux du gaz réactif et/ou du gaz inerte.

6. Procédé selon la revendication 5,
caractérisé en ce que
le flux du gaz réactif et/ou inerte est réglé en fonction d'une grandeur du procédé significative mesurée in situ.

7. Procédé selon les revendications 1 à 6,
caractérisé en ce que
la puissance électrique alimentée à travers les électrodes est réglée en fonction d'une grandeur du procédé significative mesurée in situ avec un flux maintenu constant du gaz réactif et éventuellement du gaz inerte.

8. Procédé selon la revendication 1 ou au moins une des revendications 2 à 7,
caractérisé en ce que
comme grandeur de procédé significative, on mesure l'intensité de l'émission optique sur un ou plusieurs; endroits du plasma.

9. Procédé selon la revendication 1 et au moins une des revendications 2 à 8,
caractérisé en ce que
par le réglage de la puissance de refroidissement des électrodes, on ajuste une température déterminée, de préférence élevée de la surface active des électrodes.

10. Procédé selon la revendication 1 et au moins une des revendications 2 à 9,
caractérisé en ce que
le degré de dopage des couches déposées est réglé au moyen de la puissance électrique alimentée à travers les électrodes et/ou de la puissance de refroidissement des électrodes.

11. Procédé selon la revendication 1 et au moins une des revendications 2 à 10,
caractérisé en ce qu'
est appliquée sur les électrodes une tension alternative réglable de forme sinusoïdale.

12. Procédé selon la revendication 1 et une des revendications 2 à 10,
caractérisé en ce qu'
est appliquée sur les électrodes une tension bipolaire pulsée.

13. Procédé selon la revendication 12,
caractérisé en ce que
la valeur momentanée de la puissance pendant le temps d'impulsion est réglée de façon que la puissance livrée en moyenne dans le temps, déterminée par les limites techniques du refroidissement des électrodes est dépassée.

14. Dispositif pour la réalisation du procédé selon la revendication 1,
se composant d'un dispositif de vaporisation placé sous vide pour la vaporisation directe ou indirecte du produit de vaporisation, d'électrodes, de préférence de celles, dont la surface active sont traversées par un champ magnétique à la manière d'une cathode de magnétron, de moyens pour l'introduction de gaz, et d'une source de tension pour le maintien d'une décharge non thermique pour la production de plasma,
caractérisé en ce que
- les électrodes (2 ; 2') sont disposées dans l'espace entre les substrats (4 ; 9) et le matériau de vaporisation de façon que la composante parallèle au plan du substrat de la normale à la surface de chaque électrode (2 ; 2') soit dirigée dans le sens de la densité de vapeur la plus élevée et que la normale à la surface de chaque électrode (2 ; 2') forme avec le plan du substrat un angle réglable dans l'intervalle 0 ≤ α ≤ 90°,
- chaque électrode (2 ; 2') est isolée électriquement et est reliée avec un des deux pôles d'une source de courant (7 ; 16) équipée d'un commutateur inverseur de polarisation, de préférence d'une source de tension alternative bipolaire,
- les électrodes (2 ; 2') sont munies d'un refroidissement à eau, de préférence avec une puissance de refroidissement réglable,
- les agents pour l'introduction de gaz sont placés dans l'espace compris entre le matériau de vaporisation et les substrats (4 ; 9).

15. Dispositif selon la revendication 14,
caractérisé en ce que
les deux pôles de la source de courant (7 ; 16) sont isolés électriquement aussi bien par rapport aux substrats (4 ; 9) que par rapport au dispositif de vaporisation et au dispositif d'introduction de gaz.

16. Dispositif selon les revendications 14 et 15,
caractérisé en ce que,
la forme géométrique et la grandeur des surfaces d'électrodes est largement adaptée à la surface délivrant de la vapeur du dispositif de vaporisation.

17. Dispositif selon les revendications 14 à 16,
caractérisé en ce qu'
une autre source de courant est raccordée pour ajusteur une différence de potentiel prédéfinie entre les substrats (4 ; 9) et une des électrodes (2 ; 2').

18. Dispositif selon les revendications 14 à 17,
caractérisé en ce que
d'autres dispositifs créant des champs magnétiques sont disposés au voisinage des substrats (4 ; 9), dispositifs qui guident le plasma d'une manière en principe connue.
